# EUROPEAN PATENT APPLICATION

(11) **EP 4 845 014 A1**
(43) Date of publication of application: **25.11.2026**
(21) Application number: 24921826.4
(22) Date of filing: 31.12.2024
(51) Int. Cl.: H02M 7/48

(54) **POWER CONVERTER AND DETECTION METHOD**

(30) Priority: 31.01.2024 CN 202410144755
(71) Applicant: Huawei Digital Power Technologies Co., Ltd., Shenzhen, Guangdong 518043 (CN)
(72) Inventor: MA, Tianyu, Shenzhen, Guangdong 518043 (CN); FENG, Yupeng, Shenzhen, Guangdong 518043 (CN); LIAO, Weichao, Shenzhen, Guangdong 518043 (CN); WANG, Gang, Shenzhen, Guangdong 518043 (CN); CHEN, Aitang, Shenzhen, Guangdong 518043 (CN)
(74) Representative: Huawei European IPR
(86) International application number: PCT/CN2024/144124
(87) International publication number: WO 2025/161804

(57) **Abstract**

Embodiments provide a power converter and a detection method. The power converter includes an inverter circuit, a filter capacitor, and a plurality of first switches that are in a one-to-one correspondence with three-phase inverter bridge arms and an N wire of the inverter circuit. One end of each filter capacitor is connected to a first-phase inverter bridge arm, and the other end of each filter capacitor is connected to the N wire. The first-phase inverter bridge arm of the three-phase inverter bridge arms is connected to a power grid after the first-phase inverter bridge arm is connected to a corresponding first switch and the filter capacitor. The N wire is connected to an alternating current powered device after the N wire is connected to a corresponding first switch and the filter capacitor. The first switch corresponding to the first-phase inverter bridge arm and the first switch corresponding to the N wire are controlled to be turned on. When statuses of a connection between the N wire and the power grid are different, a phase voltage of a first phase has different voltage changes. In this case, whether the N wire is disconnected from the power grid may be determined based on differences between an amplitude of the phase voltage of the first phase and amplitudes of phase voltages of the other two-phase outputs. This embodiment can achieve high-precision detection of a connection status of the N wire while reducing device costs.

## Description

This application claims priority to Chinese Patent Application No. 202410144755.2, with the China National Intellectual Property Administration on January 31, 2024 and entitled "POWER CONVERTER AND DETECTION METHOD", which is incorporated herein by reference in its entirety.

### TECHNICAL FIELD

This application relates to the field of power supply processing technologies, and in particular, to a power converter and a detection method.

### BACKGROUND

In fields such as photovoltaic power supply, energy storage power supply, a power converter needs to convert a direct current (DC) of a photovoltaic module or an energy storage module into an alternating current (AC) and transmit the alternating current to a power grid. To implement a DC/AC conversion function, an inverter circuit needs to be integrated in the power converter. The inverter circuit usually uses a circuit design with three-phase inverter bridge arms. However, in a scenario of supplying power to an unbalanced load, the inverter circuit is required to have an N wire that can carry load to facilitate performing control over imbalance. In this case, the N wire is usually added, to lead a current in the inverter circuit back to a power supply through the N wire. This ensures safety and stability of the power converter. When the N wire is disconnected from the power grid, that is, the N wire is disconnected, the current in the inverter circuit cannot be normally led back. This causes a voltage in the inverter circuit to rise, and causes damage to a circuit board of the power converter, which causes harm to the power converter or a human body.

An existing solution is as follows: A bias resistor with a different resistance value is correspondingly connected between the N wire and each of three-phase outputs of the power converter, three phase voltages are biased by using the bias resistor, and whether the N wire is disconnected may be determined based on a change between the three phase voltages. However, in this solution, a plurality of resistors need to be disposed to assist in detecting whether a coupling wire is disconnected. This leads to high device costs, and detection precision is significantly affected by other factors.

### SUMMARY

Embodiments of this application provide a power converter and a detection method, which achieves high-precision detection of whether an N wire is disconnected while reducing device costs.

To achieve the foregoing objectives, the following technical solutions are used in embodiments of this application.

According to a first aspect, an embodiment of this application provides a power converter. The power converter includes a busbar capacitor, an inverter circuit, a filter circuit, a switch component, and a control circuit. An input of the inverter circuit is configured to connect a positive direct current busbar and a negative direct current busbar. The positive direct current busbar and the negative direct current busbar are configured to connect a direct current power supply, and the busbar capacitor is connected between the positive direct current busbar and the negative direct current busbar. The inverter circuit includes three-phase inverter bridge arms and an N wire, and the N wire is connected to a midpoint of the busbar capacitor. The inverter circuit is connected to the switch component through the filter circuit. The filter circuit includes three filter capacitors, and each filter capacitor is connected between the N wire and an output end of a corresponding one-phase inverter bridge arm. The switch component is located between the filter circuit and a power grid, and includes a plurality of first switches. The plurality of first switches are respectively connected to the three-phase inverter bridge arms and the N wire in a one-to-one correspondence. The control circuit is configured to: in a startup process of the power converter, control target switches to be turned on, where the target switches include a first switch corresponding to a first-phase inverter bridge arm of the three-phase inverter bridge arms and a first switch corresponding to the N wire, and the first-phase inverter bridge arm is any one-phase inverter bridge arm of the three-phase inverter bridge arms; and when it is obtained that differences between an amplitude of a phase voltage of a first-phase output of the power converter and amplitudes of phase voltages of the other two-phase outputs are greater than or equal to a first threshold, send alarm information to prompt that the N wire is disconnected from the power grid, or control the power converter to shut down, where the first-phase output of the power converter is an output of the first-phase inverter bridge arm after the first-phase inverter bridge arm passes through the filter circuit, and the other two-phase outputs are outputs of the other two-phase inverter bridge arms after the other two-phase inverter bridge arms pass through the filter circuit. Output ends of the three-phase inverter bridge arms are output ends of the bridge arms before the three-phase inverter bridge arms pass through the filter circuit.

An amplitude of a phase voltage may usually be a peak value of the phase voltage in a control period or a valid value of the phase voltage. In a normal case, the amplitudes of the phase voltages of the three-phase outputs of the power converter are usually the same except that each of the three phases is offset by 60° of phase shift relative to the others. Therefore, that the differences between the amplitude of the phase voltage of the first-phase output and the amplitudes of the phase voltages of the other two-phase outputs are greater than or equal to the first threshold may be understood as that the difference between the amplitude of the phase voltage of the first-phase output and the amplitude of the phase voltage of any one of the other two-phase outputs is greater than or equal to the first threshold, or the differences between the amplitude of the phase voltage of the first-phase output and the amplitudes of the phase voltages of both of the other two-phase outputs are greater than or equal to the first threshold.

In a conventional design of the power converter, a filter circuit for performing alternating current filtering processing is designed on an alternating current output side of an inverter circuit, and a switch component is designed between the power grid and the alternating current output side of the inverter circuit, to ensure working safety of the power converter. In this embodiment of this application, in the power-on and startup process of the power converter, target switches (for example, the first switches connected to the three-phase inverter bridge arms and the N wire in a one-to-one correspondence) of an existing switch component may be controlled to be turned on. When the N wire is not disconnected from the power grid, turning on the target switches may enable a loop between the first-phase inverter bridge arm, a corresponding filter capacitor, the power grid, and the N wire to be formed. When the first-phase inverter bridge arm, the filter capacitor corresponding to the first-phase inverter bridge arm, the power grid, and the N wire form the loop, the filter capacitor biases the phase voltage of the first-phase output of the power converter (the phase voltage of the first-phase output is a phase voltage output after the first-phase inverter bridge arm passes through the filter circuit). Therefore, when the N wire is not disconnected from the power grid, the loop may be normally formed. In this case, the filter capacitor, as a part of the filter circuit, can normally implement a filtering function, and does not affect the phase voltage of the first-phase output. Therefore, the three phase voltages are balanced. When the N wire is disconnected from the power grid, turning on the target switches cannot enable the loop between the first-phase inverter bridge arm, the corresponding filter capacitor, the power grid, and the N wire to be formed. In this case, the filter capacitor cannot be used as a normal filter device, but is used as a bias device to bias the phase voltage of the first-phase output. In this case, the phase voltage of the first-phase output is obviously different from the phase voltages of the other two-phase outputs. Therefore, the control circuit may detect, based on whether differences between the phase voltage of the first-phase output and the phase voltages of the other two-phase outputs are greater than or equal to the preset first threshold, whether the N wire is disconnected from the power grid. After detecting that the N wire is disconnected, the control circuit may output alarm information, or may control the power converter to shut down. In the foregoing detection method, the bias device for biasing a phase voltage does not need to be additionally disposed, which saves device costs. In addition, when the filter capacitor is used as the bias device, a bias capability of the filter capacitor is not affected by another device in the filter circuit. On a basis that the bias capability keeps stable, a phase voltage obtained after biasing in an actual case tends to be a phase voltage obtained after biasing in an ideal case, and a value of the preset first threshold is related to the phase voltage obtained after biasing in the ideal case. Therefore, this embodiment of this application can improve detection precision while reducing costs.

For example, the direct current power supply may be a photovoltaic power generation device (for example, a photovoltaic array), a wind power generation device, a hydropower generation device, an energy storage apparatus, or the like.

For example, startup of the power converter means that the power converter is powered on and started after the power converter is connected to a working power supply of a device. In the startup process of the power converter, the control circuit in the power converter is also powered on. After the control circuit is powered on, a self-check process may be performed, in which various working status information of the power conversion apparatus may be detected, to ensure working stability and safety of the power conversion apparatus. For example, detection of whether the N wire is disconnected from the power grid is performed. In this way, subsequent working of a direct current/alternating current conversion circuit can be performed. The startup process of the power conversion apparatus in this application is a process in which the power conversion apparatus performs the self-check after the power conversion apparatus is powered on.

In some possible implementations, the switch component further includes a plurality of second switches. The plurality of second switches are connected in series to the plurality of first switches in a one-to-one correspondence. The three-phase inverter bridge arms and the N wire are respectively configured to connect to the power grid through the first switches and the second switches that are in a one-to-one correspondence. Each first switch is located between a corresponding second switch and the filter circuit. The target switches further include the plurality of second switches. Controlling the target switches to be turned on includes: first controlling the plurality of second switches to be turned on, and then controlling the first switch corresponding to the first-phase inverter bridge arm and the first switch corresponding to the N wire to be turned on. In this embodiment of this application, to ensure working safety of the power converter, switches in a plurality of levels may be disposed for protection. For example, the power converter is an inverter. The first switch may be a relay that is in the inverter and that is close to an inverter circuit side, and the second switch may be a relay that is in the inverter and that is close to a power grid side. When the switch component includes components of a plurality of levels, the switch on the power grid side may be first turned on, and then the switch on the inverter side is turned on.

In an example, alternatively, when a corresponding first switch is controlled to be turned on, the first switch corresponding to the first-phase inverter bridge arm may be first controlled to be turned on, and then the first switch corresponding to the N wire is controlled to be turned on, which improves detection safety and the like.

In some possible implementations, the control circuit is further configured to: before controlling the target switches to be turned on, control the inverter circuit to send an open-loop PWM signal; and after controlling the target switches to be turned on, control the inverter circuit to stop sending the open-loop PWM signal. In this embodiment of this application, the inverter circuit is controlled to send the open-loop PWM signal before the target switches are turned on, and the inverter circuit is controlled to stop sending the open-loop PWM signal after the target switches are turned on. In this way, the inverter circuit can send the PWM signal only in a short period of time, a size of a finally sent PWM signal can meet a detection requirement, and a detection safety problem caused by an excessively large size of the sent PWM signal does not occur.

In some possible implementations, the control circuit is further configured to: before obtaining the phase voltage of the first-phase output of the power converter, detect whether the target switches are turned on. In this embodiment of this application, before the phase voltage is obtained for final detection, whether the target switches are turned on may be further verified. After it is verified that the target switches have been turned on, final detection confirmation processing is performed. A re-verification operation is set, which can improve safety of detection processing, and can avoid a safety problem caused by detection performed when all or a part of the target switches are not turned on.

For example, the power converter further includes a sampling circuit. The sampling circuit is separately connected to the switch component and the control circuit. The sampling circuit is configured to obtain voltages at two ends of each of the target switches. The control circuit is specifically configured to: when a difference between voltages at two ends of any switch of the target switches is less than a preset threshold, determine that the switch is turned on. In this embodiment of this application, the sampling circuit is usually disposed in the power converter. A working status and the like of each circuit component in the power converter are detected by using the sampling circuit. An input voltage and an output voltage of each of the target switches are obtained through sampling by using the sampling circuit. The control circuit may determine, based on voltage information obtained by the sampling circuit, whether a corresponding switch is turned on. After a switch is turned on, an electrical signal can normally flow. In this case, a difference between an input voltage and an output voltage of the switch is small. When a switch is turned off, the electrical signal cannot normally flow. In this case, a voltage at an input end of the switch is significantly greater than a voltage at an output end of the switch. Therefore, when a difference between an input voltage and an output voltage of a switch is less than a preset threshold, the control circuit may verify and confirm that the switch is turned on.

In some possible implementations, the control circuit is further configured to: after determining that the N wire is disconnected from the power grid, control the target switches to be turned off. In this embodiment of this application, after detection is completed and it is determined that the N wire is disconnected from the power grid, it indicates that disconnection of the N wire poses a safety risk to the power converter. The target switches have been controlled to be turned on for detection processing. Therefore, for safety of the power converter, the target switches may be further controlled to be turned off, to ensure safety of the device and personal safety of a worker.

According to a second aspect, an embodiment of this application further provides a detection method, and the detection method is applied to a power converter. The power converter includes a busbar capacitor, an inverter circuit, a filter circuit, a switch component, and a control circuit. An input of the inverter circuit is configured to connect a positive direct current busbar and a negative direct current busbar. The positive direct current busbar and the negative direct current busbar are configured to connect a direct current power supply, and the busbar capacitor is connected between the positive direct current busbar and the negative direct current busbar. The inverter circuit includes three-phase inverter bridge arms and an N wire, and the N wire is connected to a midpoint of the busbar capacitor. The inverter circuit is connected to the switch component through the filter circuit. The filter circuit includes three filter capacitors, and each filter capacitor is connected between the N wire and an output end of a corresponding one-phase inverter bridge arm. The switch component is located between the filter circuit and a power grid, and includes a plurality of first switches. The plurality of first switches are respectively connected to the three-phase inverter bridge arms and the N wire in a one-to-one correspondence. The method includes: in a power-on and startup process of the power converter, controlling target switches to be turned on, where the target switches include a first switch corresponding to a first-phase inverter bridge arm of the three-phase inverter bridge arms and a first switch corresponding to the N wire, and the first-phase inverter bridge arm is any one-phase inverter bridge arm of the three-phase inverter bridge arms; and when it is obtained that differences between an amplitude of a phase voltage of a first-phase output of the power converter and amplitudes of phase voltages of the other two-phase outputs are greater than or equal to a first threshold, sending alarm information to prompt that the N wire is disconnected from the power grid, or controlling the power converter to shut down, where the first-phase output of the power converter is an output of the first-phase inverter bridge arm after the first-phase inverter bridge arm passes through the filter circuit, and the other two-phase outputs are outputs of the other two-phase inverter bridge arms after the other two-phase inverter bridge arms pass through the filter circuit.

In some possible implementations, the switch component further includes a plurality of second switches. The plurality of second switches are connected in series to the plurality of first switches in a one-to-one correspondence. The three-phase inverter bridge arms and the N wire are respectively configured to connect to the power grid through the first switches and the second switches that are in a one-to-one correspondence. Each first switch is located between a corresponding second switch and the filter circuit. The target switches further include the plurality of second switches. Controlling the target switches to be turned on includes: first controlling the plurality of second switches to be turned on, and then controlling the first switch corresponding to the first-phase inverter bridge arm and the first switch corresponding to the N wire to be turned on.

In some possible implementations, the method further includes: before controlling the target switches to be turned on, controlling the inverter circuit to send an open-loop PWM signal; and after controlling the target switches to be turned on, controlling the inverter circuit to stop sending the open-loop PWM signal.

In some possible implementations, the method further includes: before obtaining phase voltages corresponding to the three-phase inverter bridge arms, detecting whether the target switches are turned on.

In some possible implementations, the power converter further includes a sampling circuit, and the sampling circuit is connected to the switch component. Detecting whether the target switches are turned on includes: obtaining voltages at two ends of each of the target switches through sampling by using the sampling circuit; and when a difference between voltages at two ends of any switch of the target switches is less than a preset threshold, determining that the switch is turned on.

In some possible implementations, the method further includes: after determining that the N wire is disconnected from the power grid, controlling the target switches to be turned off.

For technical principles and beneficial effects of the second aspect, refer to related descriptions of the first aspect. Details are not described herein again.

### BRIEF DESCRIPTION OF DRAWINGS

FIG. 1 is a diagram of a structure of a photovoltaic system according to an embodiment of this application;
FIG. 2 is a diagram of a structure of an uninterruptible power system according to an embodiment of this application;
FIG. 3 is a diagram 1 of a structure of a power converter according to an embodiment of this application;
FIG. 4 is a diagram of a structure of a power converter in the conventional technology according to an embodiment of this application;
FIG. 5 is a diagram in which corresponding phase voltages change with time before and after an N wire is disconnected from a power grid in the conventional technology according to an embodiment of this application;
FIG. 6 is a diagram of a structure of a power converter according to an embodiment of this application;
FIG. 7 is a diagram of another structure of a power converter according to an embodiment of this application;
FIG. 8 is a diagram of another structure of a power converter according to an embodiment of this application;
FIG. 9 is a schematic flowchart of a detection method according to an embodiment of this application;
FIG. 10 is a diagram after target switches of a power converter are controlled to be turned on according to an embodiment of this application;
FIG. 11 is a schematic flowchart of another detection method according to an embodiment of this application; and
FIG. 12 is a schematic flowchart of another detection method according to an embodiment of this application.

### DESCRIPTION OF EMBODIMENTS

It should be noted that the terms "first", "second", and the like in embodiments of this application are merely used to distinguish between features of a same type, and cannot be understood as an indication of relative importance, a quantity, a sequence, or the like.

The term "example", "for example", or the like in embodiments of this application is used to represent an example, an illustration, or a description. Any embodiment or design scheme described as an "example" or "for example" in this application should not be explained as being more preferred or having more advantages than another embodiment or design scheme. To be precise, use of the word such as "example" or "for example" is intended to present a relative concept in a specific manner.

The terms "coupling" and "connection" in embodiments of this application should be understood in a broad sense. For example, the "connection" may be a physical direct connection, or may be an indirect connection implemented through an electronic component, for example, a connection implemented through a resistor, an inductor, a capacitor, or another electronic component.

A power converter is a common device in a power supply system. The power converter is applicable to a device with three-phase four-bridge-arm topology, such as an inverter or a power conversion system (power conversion system, PCS). Based on different power supply systems, the power converter is applicable to different application scenarios, for example, a photovoltaic power supply scenario, an energy storage power supply scenario, a hydropower generation scenario, and a wind power generation scenario, to provide an alternating current for a power grid, a load, and the like.

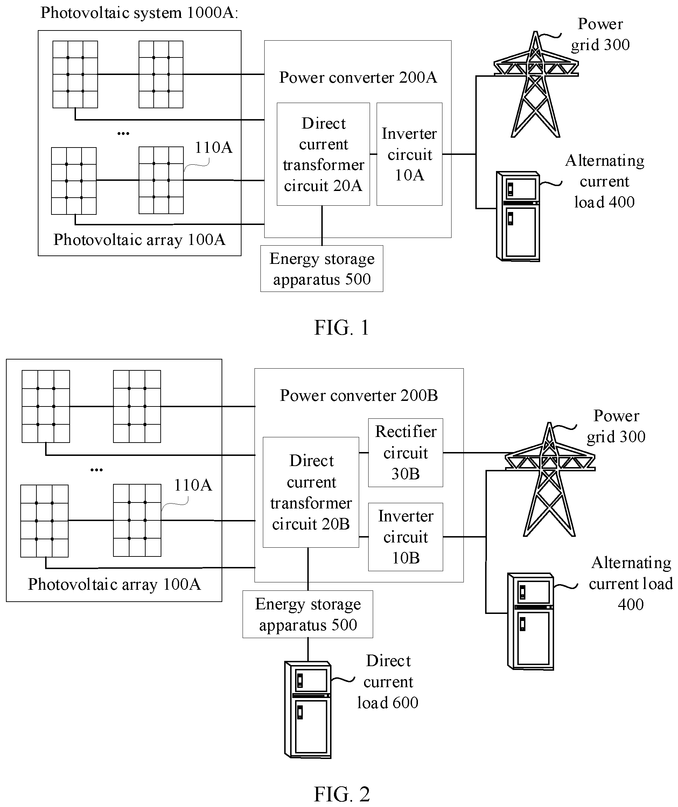

FIG. 1 is an example of a diagram of an application scenario of a photovoltaic system. As shown in FIG. 1, the photovoltaic system 1000A may include a photovoltaic array 100A, a power converter 200A, and a power grid 300/an alternating current load 400. One photovoltaic array 100A may be obtained by connecting one or more photovoltaic modules 110A. The power converter 200A includes an inverter circuit 10A (that is, a DC/AC conversion circuit). A direct current generated by the photovoltaic array 100A is converted into an alternating current through by the inverter circuit 10A of the power converter 200A, and then is transmitted to the power grid 300/the alternating current load 400. In some photovoltaic and energy storage integration scenarios, the photovoltaic system may further include an energy storage apparatus 500, and the power converter 200A further includes a direct current transformer circuit 20A (that is, a DC/DC conversion circuit). The energy storage apparatus 500 may be connected to the direct current transformer circuit 20A. Electric energy generated by the photovoltaic array 100A may be charged to the energy storage apparatus 500 after boost or buck conversion is performed on the electric energy through the direct current transformer circuit 20A. When the electric energy generated by the photovoltaic array 100A is insufficient to supply power to the power grid 300/the alternating current load 400, electric energy stored in the energy storage apparatus 500 may be transmitted to the power grid 300/the alternating current load 400 through the direct current transformer circuit 20A and the inverter circuit 10A in the power converter 200A. For descriptions of power converters in a hydraulic power supply scenario a wind power supply scenario, refer to related descriptions of the photovoltaic power supply scenario. Details are not described herein again.

FIG. 2 is an example of a diagram of an application scenario in which the power conversion system (PCS) supplies power. In a PCS power supply scenario, the PCS provided in this application may be a power converter 200B. The power converter 200B is separately connected to the power grid 300, the energy storage apparatus 500, and the alternating current load 400. The PCS is also referred to as a bidirectional converter, and includes an inverter circuit 10B (that is, a DC/AC conversion circuit) and a rectifier circuit 30B (that is, an AC/DC conversion circuit). The PCS may convert a direct current into an alternating current through the inverter circuit 10B, or may convert an alternating current into a direct current through the rectifier circuit 30B. For example, the bidirectional converter may obtain an alternating current from the power grid 300, and convert the alternating current into a direct current through the rectifier circuit 30B, to charge the energy storage apparatus 500. Alternatively, a direct current stored in the energy storage apparatus 500 may be converted into an alternating current through the inverter circuit 10B after the direct current transformer circuit 20B performs direct current voltage conversion processing on the direct current. Converted electric power is transmitted to the necessary alternating current load 400 or the power grid 300. Further, the energy storage apparatus 500 may further supply power to a direct current load 600.

In the photovoltaic and energy storage integration scenario, the energy storage apparatus 500 may further obtain a direct current from the photovoltaic array 100 for charging.

The power converter 200B further includes a direct current transformer circuit 20B (that is, a DC/DC conversion circuit). The energy storage apparatus 500 may be connected to the direct current transformer circuit 20B. Electric energy generated by the power grid 300 or the photovoltaic array 100 may be charged to the energy storage apparatus 500 after boost or buck conversion is performed on the electric energy through the direct current transformer circuit 20B.

It may be understood that the foregoing is merely an example of an application scenario of the power converter provided in this application, but is not exhaustive. The application scenario is not limited in this application.

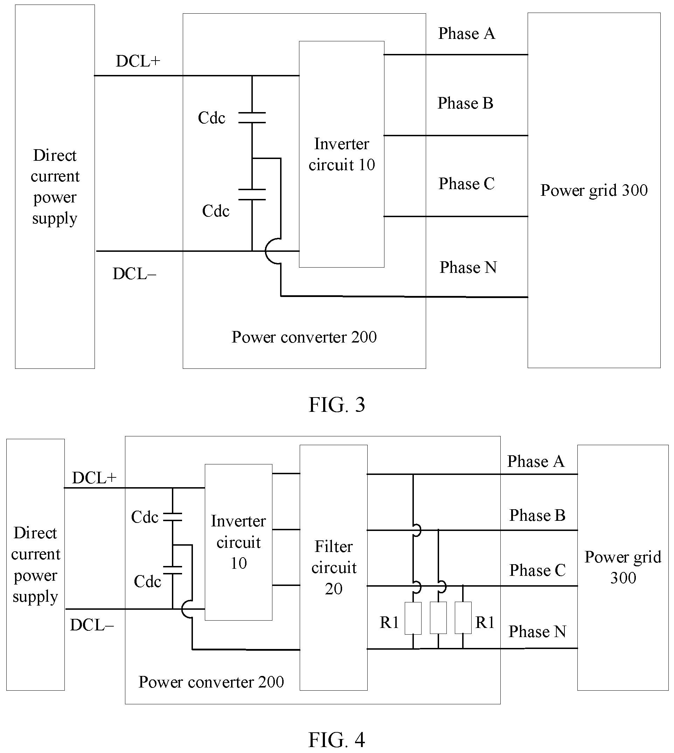

To meet a scenario of supplying power to an unbalanced load, an embodiment of this application provides a power converter. As shown in FIG. 3, an inverter circuit 10 of the power converter 200 uses a circuit design with three-phase four bridge arms. To be specific, a fourth bridge arm as a phase-N bridge arm (also referred to as an N wire) is added on a basis of three-phase three bridge arms (for example, a phase A, a phase B, and a phase C) of the inverter circuit. The N wire may generate a zero-sequence voltage when load is unbalanced, to control the unbalanced load. A positive direct current input end and a negative direct current input end of the power converter 200 are respectively connected to a positive direct current busbar DCL+ and a negative direct current busbar DCL- in a one-to-one correspondence. The positive direct current busbar DCL+ and the negative direct current busbar DCL- are configured to connect to a direct current power supply (for example, the photovoltaic array 100A shown in FIG. 1 or the energy storage apparatus 500 shown in FIG. 1 and FIG. 2). A busbar capacitor Cdc is connected and disposed between the positive direct current busbar DCL+ and the negative direct current busbar DCL-. Specifically, two same busbar capacitors Cdc may be used, and the N wire is connected to a connection point of the two busbar capacitors Cdc, that is, a midpoint. A current in the inverter circuit 10 is led back to the power supply through the N wire. This ensures safety and stability of the power converter 200. However, in actual application, the N wire may be disconnected from the power grid 300, that is, the N wire is disconnected. When the N wire is disconnected from the inverter circuit 10, the current in the inverter circuit 10 cannot be normally led back. When the inverter circuit 10 starts working (for example, starts to input a direct current, and performs processing of converting the direct current into an alternating current) or is working, a voltage in the inverter circuit 10 rises, and a circuit board of the power converter 200 is damaged, which causes harm to the power converter or a human body.

In a possible implementation, whether the N wire is disconnected from the power grid 300 may be detected by using a bias resistor. As shown in FIG. 4, the power converter 200 includes the busbar capacitor Cdc, the inverter circuit 10, a filter circuit 20, a control circuit 40, and a plurality of bias resistors R1. A positive direct current input and a negative direct current input of the inverter circuit 10 are respectively connected to the positive direct current busbar DCL+ and the negative direct current busbar DCL- in a one-to-one correspondence. The positive direct current busbar DCL+ and the negative direct current busbar DCL- are configured to connect to the direct current power supply (for example, the photovoltaic array 100A shown in FIG. 1 or the internal energy storage apparatus 20B shown in FIG. 2). The busbar capacitor Cdc is connected between the positive direct current busbar DCL+ and the negative direct current busbar DCL-. The N wire is connected to the midpoint of the busbar capacitor Cdc. The three-phase inverter bridge arm ends and the N wire of the inverter circuit 10 are separately connected to the power grid 300 or the load 400 through the filter circuit 20. The plurality of bias resistors R1 are in a one-to-one correspondence with the three-phase inverter bridge arm ends. A first end of each bias resistor R1 is connected to a corresponding one-phase inverter bridge arm end of the three-phase inverter bridge arm ends, and a second end of each bias resistor R1 is connected to the N wire. The control circuit 40 is configured to determine, based on differences between three phase voltages of the power converter 200, whether the N wire is disconnected.

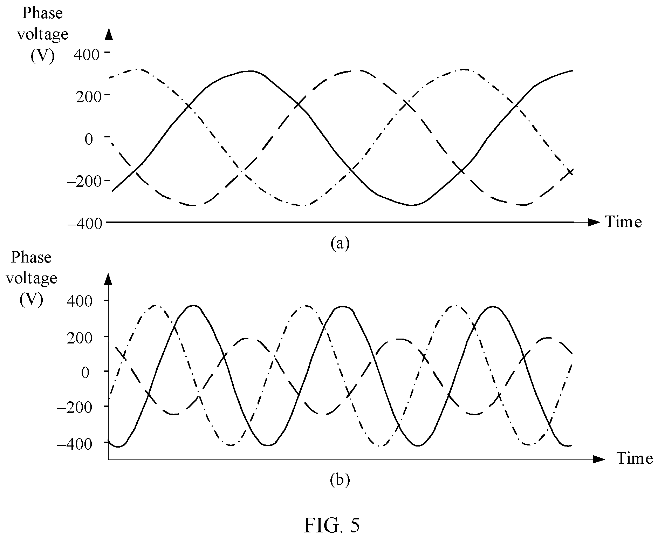

In the conventional technology, as shown in FIG. 4, the control circuit 40 is connected to the inverter circuit 10, and may control a working status and the like of the inverter circuit 10 through a control signal. The inverter circuit 10 obtains a direct current from the direct current power supply through the direct current busbar, and after performing inversion processing on the direct current, outputs an alternating current from the three-phase inverter bridge arm ends of the inverter circuit 10. A current in the inverter circuit 10 may be led back to the direct current power supply side through the N wire. This ensures safety and stability of a device. When the N wire is disconnected, a voltage in the circuit rises, which may cause a safety risk to the device or even a human body. In the embodiment in FIG. 4, three bias resistors R1 may be disposed in the filter circuit 20. Resistance values of the three bias resistors R1 are different. Each bias resistor R1 corresponds to a one-phase inverter bridge arm end of the three-phase inverter bridge arm ends, and an each-phase inverter bridge arm end is coupled to the N wire through a corresponding bias resistor R1. (a) in FIG. 5 is a diagram in which voltages of the three-phase inverter bridge arm ends change with time when a coupling wire of the N wire is not disconnected. It can be learned that changes of voltage amplitudes of phase voltages between the three-phase inverter bridge arm ends tend to be balanced and stable. (b) in FIG. 5 is a diagram in which the voltages of the three-phase inverter bridge arm ends change with time when the N wire is disconnected. It can be learned that due to existence of the plurality of bias resistors R1, after the coupling wire of the N wire is disconnected, the phase voltages are biased, and changes of signal amplitudes between the three phase voltages corresponding to the three-phase inverter bridge arm ends are that there are specific voltage differences. The control circuit 40 may determine, based on the changes of the phase voltages, whether the coupling wire of the N wire is disconnected. This ensures working safety and stability of the power converter 200. However, in the conventional technology shown in FIG. 4, a plurality of bias resistors R1 need to be disposed, which increases device costs. In addition, usually, a filter circuit 20 is further disposed between a first inverter circuit 11A and the power grid 300 or the load 400. The filter circuit 20 affects a bias capability of the bias resistor R1, which reduces detection precision.

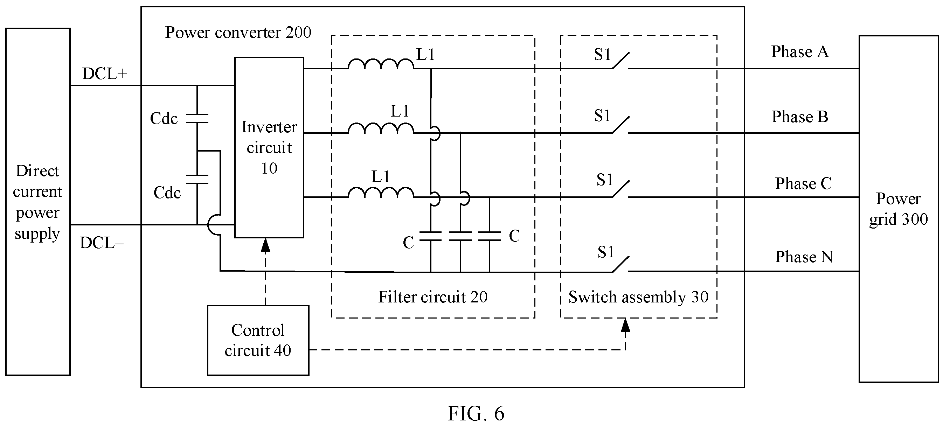

To implement high-precision detection of whether the N wire is disconnected while reducing device costs, in some possible implementations, detection of whether the N wire is disconnected may be implemented by controlling switches. As shown in FIG. 6, the power converter 200 includes the busbar capacitor Cdc, the inverter circuit 10, the filter circuit 20, a switch component 30, and the control circuit 40. The positive direct current input and the negative direct current input of the inverter circuit 10 are respectively connected to the positive direct current busbar DCL+ and the negative direct current busbar DCL- in a one-to-one correspondence. The positive direct current busbar DCL+ and the negative direct current busbar DCL- are configured to connect to the direct current power supply (for example, the photovoltaic array 100A shown in FIG. 1 or the energy storage apparatus 500 shown in FIG. 2). The busbar capacitor Cdc is connected between the positive direct current busbar DCL+ and the negative direct current busbar DCL-. The N wire is connected to the midpoint of the busbar capacitor Cdc. The inverter circuit 10 is connected to the switch component 30 through the filter circuit 20. The filter circuit 20 includes three filter capacitors C, and each filter capacitor C is connected between the N wire and an output end of a corresponding one-phase inverter bridge arm. The switch component 30 is located between the filter circuit 20 and the power grid 300, and includes a plurality of first switches S1. The plurality of first switches S1 are respectively connected to the three-phase inverter bridge arm ends and the N wire in a one-to-one correspondence. The control circuit 40 is configured to: in a startup process of the power converter, control target switches to be turned on, where the target switches include a first switch S1 corresponding to a first-phase inverter bridge arm of the three-phase inverter bridge arms and a first switch S1 corresponding to the N wire, and the first-phase inverter bridge arm is any one-phase inverter bridge arm of the three-phase inverter bridge arms; and when it is obtained that differences between a phase voltage of a first-phase output and phase voltages of the other two-phase outputs are greater than or equal to a first threshold, send alarm information to prompt that the N wire is disconnected from the power grid 300, or control the power converter 200 to shut down, where the first-phase output of the power converter is an output of the first-phase inverter bridge arm after the first-phase inverter bridge arm passes through the filter circuit 20, and the other two-phase outputs are outputs of the other two-phase inverter bridge arms after the other two-phase inverter bridge arms pass through the filter circuit 20.

For example, startup of the power converter 200 means that the power converter 200 is powered on and started after the power converter 200 is connected to a working power supply of a device. In the startup process of the power converter 200, to ensure operation safety of the power converter 200, related detection may be performed. For example, detection of whether the N wire is disconnected from the power grid 300 is performed.

For example, the filter circuit 20 may further include three filter inductors L, and the three filter inductors L are connected in series to the three-phase inverter bridge arms in a one-to-one correspondence.

In this embodiment of this application, to ensure power supply safety and reliability of the power converter 200, the switch component 30 is usually disposed on the three-phase inverter bridge arm ends and the N wire of the power converter 200. For example, as shown in FIG. 6, a first switch S1 is correspondingly disposed between the each-phase inverter bridge arm end of the three-phase inverter bridge arm ends and the N wire. Therefore, compared with the conventional technology shown in FIG. 4, in the embodiment shown in FIG. 6, a bias device (for example, the bias resistor R1 in FIG. 4) for biasing the phase voltage may not be additionally disposed, and whether the N wire is disconnected may be detected by using an existing filter device as the bias device. A specific detection method is: At a power-on and startup stage of the power converter 200, the first switch S1 corresponding to the first-phase inverter bridge arm of the three-phase inverter bridge arms and the first switch S1 corresponding to the N wire are turned on. After the embodiment shown in FIG. 6 is used, and after the first switch S1 corresponding to the first-phase inverter bridge arm is turned on, if the N wire is not disconnected, a loop between the first-phase bridge arm end, the power grid 300, and the N wire may be formed. In this case, the filter capacitor C normally performs filtering processing, and voltage values of the phase voltages are not greatly affected. If the N wire is disconnected, the loop between the first-phase bridge arm end, the power grid 300, and the N wire cannot be formed. In this case, the filter capacitor C cannot form a normal filter structure, but is used as a bias device that is connected to the first-phase bridge arm end. After the phase voltages are biased based on the corresponding filter capacitor C, for a diagram in which the phase voltages of the three phases of the power converter change with time, refer to the diagram corresponding to (b) in FIG. 5. It can be seen from (b) in FIG. 5 that after the N wire is disconnected, the voltage of the first-phase output of the power converter is greatly reduced by biasing of the filter capacitor C. In this way, the phase voltage of the first-phase output is obviously lower than the phase voltages of the other two-phase outputs. Therefore, after detecting that the differences between the phase voltage of the first-phase output and the phase voltages of the other two-phase outputs are greater than or equal to the preset first threshold, the control circuit 40 may determine that the N wire is disconnected from the power grid 300. In this embodiment of this application, an existing filter device (that is, the filter capacitor C) in the filter circuit 20 is reused as a device for biasing a phase voltage, and a phase voltage of one of the three phases is biased by controlling a switch. Whether the N wire is disconnected is detected based on the differences between the three phase voltages. Compared with the conventional technology in FIG. 4, the bias device does not need to be additionally disposed in the embodiment in FIG. 6. This reduces device costs. In addition, when the filter capacitor C is used as the bias device, the filter capacitor C is not affected by the filter circuit 20. On a basis that a bias capability keeps stable, a phase voltage obtained after biasing in an actual case tends to be a phase voltage obtained after biasing in an ideal case, and a value of the preset first threshold is related to the phase voltage obtained after biasing in the ideal case. Therefore, detection precision in the embodiment shown in FIG. 6 is much higher than that in the conventional technology shown in FIG. 4.

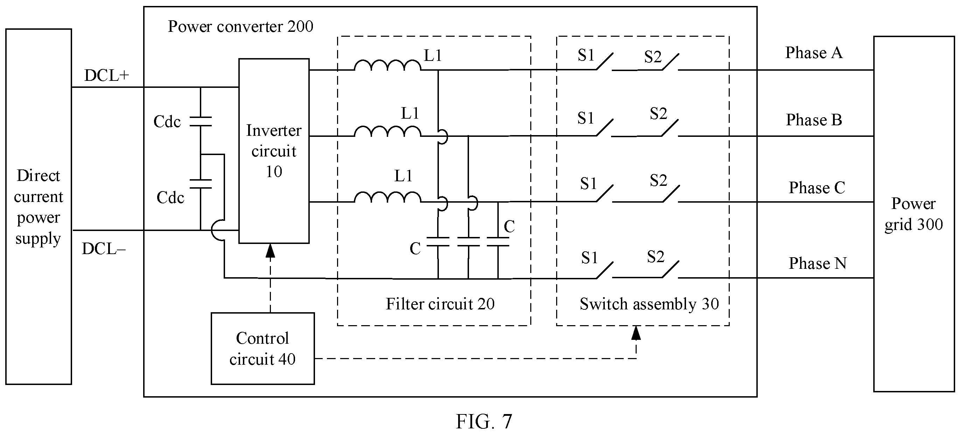

In some possible implementations, as shown in FIG. 7, the switch component 30 further includes a plurality of second switches S2. The plurality of second switches S2 are connected in series to the plurality of first switches S1 in a one-to-one correspondence. The three-phase inverter bridge arms and the N wire are respectively configured to connect to the power grid 300 through the first switches S1 and the second switches S2 that are in a one-to-one correspondence. Each first switch S1 is located between a corresponding second switch S2 and the filter circuit 20. In this embodiment of this application, to ensure working safety of the power converter 200, during actual application, a plurality of groups of switches may be disposed in the switch component 30 to separately ensure safety on an inverter circuit 10 side and a power grid 300 side. In this case, the first switch S1 may be used as a switch device on the inverter circuit 10 side, and the second switch S may be used as a switch device on the power grid 300 side of the power converter 200. In this case, if the N wire needs to be detected, the target switches that need to be turned on during detection further need to include the foregoing plurality of second switches S2.

For example, the plurality of first switches S1 may be relays on an inverter side. The plurality of second switches S2 may be relays on the power grid side.

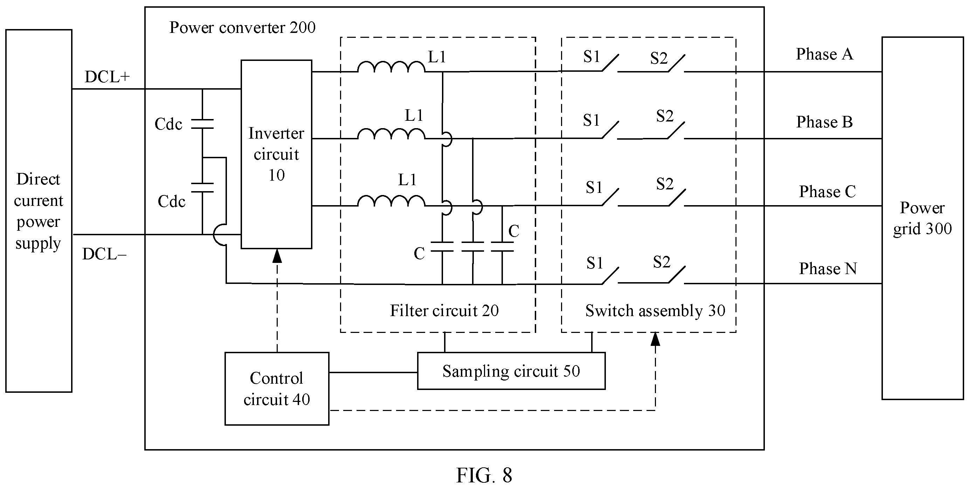

In some possible implementations, as shown in FIG. 8, the power converter 200 further includes a sampling circuit 50. The sampling circuit 50 is separately connected to the switch component 30 and the control circuit 40. The sampling circuit 50 is configured to obtain voltages at two ends of each of the target switches, that is, an input voltage and an output voltage. In this case, the control circuit 40 may determine, based on a difference between voltages at two ends of each switch, whether the switch is turned on.

For example, the sampling circuit 50 is further connected to the filter circuit 20. The sampling circuit 50 may be further configured to obtain the phase voltages (that is, voltages at an output of the filter circuit 20) of the three-phase outputs of the power converter 200. The control circuit 40 may obtain the phase voltages of the three-phase outputs from the sampling circuit 50, and determine, based on the obtained phase voltages, whether the N wire is disconnected.

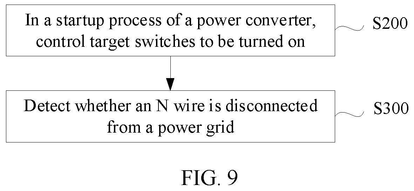

Based on a second processing circuit 100B shown in FIG. 6, FIG. 7, and FIG. 8, a detection method that includes operations in steps S200 and S300 shown in FIG. 9 may be performed.

S200: In the startup process of the power converter 200, control the target switches to be turned on.

In some possible implementations, in response to power-on and startup of the power converter 200, the control circuit 40 starts detecting whether the coupling wire of the N wire is disconnected. In this case, in step S200, any one-phase inverter bridge arm of the three-phase inverter bridge arms may be used as the first-phase inverter bridge arm.

For example, when the N wire of the power converter 200 is not disconnected from the power grid 300, turning on the target switches may enable a loop between the first-phase inverter bridge arm, a corresponding filter capacitor C, the power grid 300, and the N wire to be formed. In this case, the filter capacitor C performs filtering, and the phase voltage of the first-phase output is not affected. That is, the amplitude of the phase voltage of the first-phase output is similar to the amplitudes of the phase voltages of the other two-phase outputs.

For example, when the N wire of the power converter 200 is disconnected from the power grid 300, turning on the target switches cannot enable the loop between the first-phase inverter bridge arm, the corresponding filter capacitor C, the power grid 300, and the N wire to be formed. In this case, the filter capacitor C cannot perform filtering, and the filter capacitor C that is connected to the first-phase inverter bridge arm is used as the bias device to bias the phase voltage of the first-phase output. Therefore, the differences between the amplitude of the phase voltage of the first-phase output and the amplitudes of the phase voltages of the other two-phase outputs are greater than or equal to the first threshold.

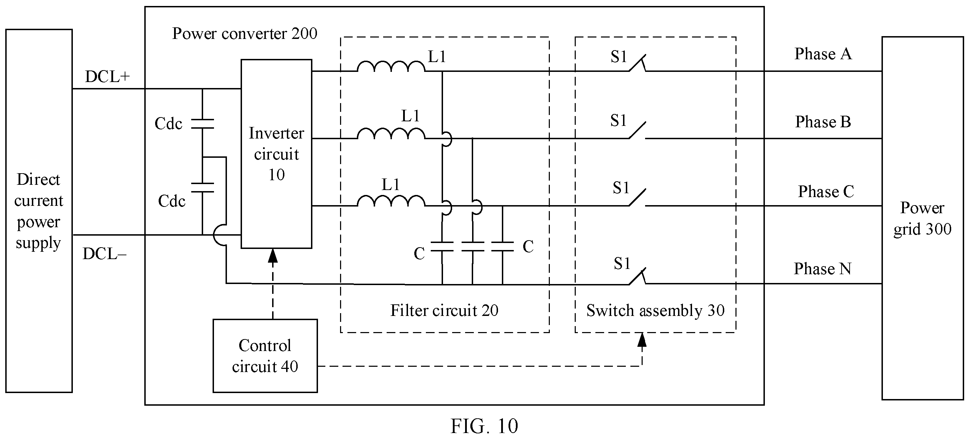

For example, as shown in FIG. 10, when the switch component 30 disposed in the power converter 200 includes a plurality of first switches S1 on the inverter circuit 10 side, an example in which the phase-A inverter bridge arm is the first-phase inverter bridge arm is used, and in response to the inverter circuit 10 starting working, the control circuit 40 may control a first switch S1 corresponding to the phase-A inverter bridge arm and the first switch S1 corresponding to the N wire to be turned on. In this case, if the N wire is disconnected from the power grid 300, a phase voltage of a phase-A output of the power converter 200 may be biased by using a corresponding filter capacitor C between the phase-A inverter bridge arm and the N wire. For a specific diagram of effect obtained after biasing, refer to (b) in FIG. 5.

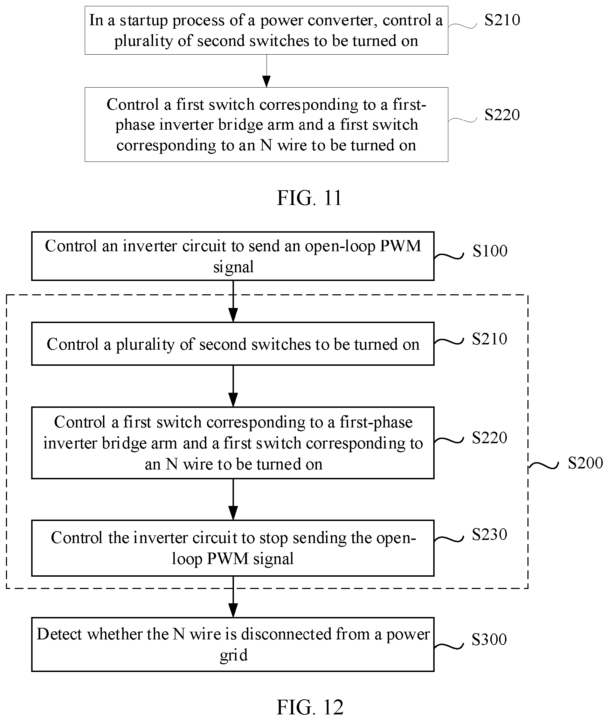

For example, when the switch component 30 disposed in the power converter 200 further includes a plurality of second switches S on the power grid side shown in FIG. 8, in a process of detecting the N wire, the target switches that need to be turned on further include a plurality of second switches S2. In this case, S200 may be specifically sub-operations in steps S210 and S220 shown in FIG. 11.

S210: In the startup process of the power converter 200, control the plurality of second switches S2 to be turned on.

S220: Control the first switch S1 corresponding to the first-phase inverter bridge arm and the first switch S1 corresponding to the N wire to be turned on.

In the embodiment shown in FIG. 11 in this application, the example in which the phase-A inverter bridge arm is the first-phase inverter bridge arm is used. To ensure detection safety, when the first switches S1 and the second switches S2 need to be controlled to be turned on, the switches on the power grid side (that is, the plurality of second switches S2) may be first controlled to be turned on, and then the first switch S1 corresponding to the first-phase inverter bridge arm (that is, the phase-A inverter bridge arm) and the first switch S1 corresponding to the N wire are controlled to be turned on. For example, alternatively, when a corresponding first switch S1 is controlled to be turned on, the first switch S1 corresponding to the first-phase inverter bridge arm may be first controlled to be turned on, and then the first switch S1 corresponding to the N wire is controlled to be turned on. For technical principles and beneficial effects of using the phase-B inverter bridge arm or the phase-C inverter bridge arm as the first-phase inverter bridge arm, refer to related descriptions of using the phase-A inverter bridge arm as the first-phase inverter bridge arm. Details are not described herein again.

S300: Detect whether the N wire is disconnected from the power grid 300.

In some possible implementations, as shown in FIG. 10, the phase voltages of the three-phase outputs are obtained through sampling by using the sampling circuit 50 disposed in the power converter 200. The control circuit 40 determines, based on the differences between the amplitude of the phase voltage of the first-phase output and the amplitudes of the phase voltages of the other two-phase outputs, whether the N wire is disconnected from the power grid 300. For a diagram of effect of biasing performed by the filter capacitor C on the phase voltage of the first-phase output, refer to the diagram of a voltage change after a corresponding phase voltage is biased in the conventional technology in FIG. 4. As shown in (b) in FIG. 5, after the phase voltage of the first-phase output is biased, differences between the amplitude of the phase voltage of the first-phase output and the amplitudes of the phase voltages of the other two-phase outputs increase. Whether the N wire is disconnected can be determined by detecting whether the differences between the phase voltages are greater than or equal to the preset first threshold. When it is detected that the differences between the amplitude of the phase voltage of the first-phase output and the amplitudes of the phase voltages of the other two-phase outputs are greater than or equal to the first threshold, it is determined that the N wire is disconnected from the power grid 300.

In an example, to ensure reliability and safety when the N wire is detected, before the phase voltages are obtained through sampling by using the sampling circuit 50 to detect the N wire, verification may be further performed, by using the sampling circuit 50, to detect whether each of the target switches is turned on. For example, as shown in FIG. 10, the first switch S1 corresponding to the first-phase inverter bridge arm and the first switch S1 corresponding to the N wire are verified. Alternatively, the first switch S1 corresponding to the first-phase inverter bridge arm, the first switch S1 corresponding to the N wire, and the plurality of second switches S2 are verified. Specifically, voltages at two ends of a to-be-verified switch, that is, a voltage at an input end and a voltage at an output end, may be obtained by using the sampling circuit 50, and whether the to-be-verified switch is turned on is determined based on the voltage at the input end and the voltage at the output end. After it is determined that all of the target switches are turned on, the phase voltages are through sampling, to detect whether the N wire is disconnected from the power grid 300. For example, for any one of the target switches, when a difference between voltages at two ends of a corresponding switch is less than a preset threshold, the control circuit 40 may determine that the switch is turned on. In this embodiment of this application, a current transmission path is formed after a switch is turned on. When a current flows through a switch, a difference between a voltage at an input end and a voltage at an output end of the switch is small (the difference usually is a voltage drop parameter value of the switch device). If the switch is turned off, the current cannot flow through the output end of the switch from the input end of the switch. In this case, the difference between the voltage at the input end and the voltage at the output end of the switch is large. Therefore, the sampling circuit 50 performs sampling to obtain values of a voltage at an input end and a voltage at an output end of each of the target switches, and the control circuit 40 may determine, based on a difference between the voltage at the input end and the voltage at the output end of the switch, whether the switch is turned on.

In some possible implementations, after determining that the N wire is disconnected from the power grid 300, the control circuit 40 may output related alarm indication information. The alarm indication information indicates that the N wire has a disconnection fault, and the like.

In some possible implementations, after determining that the N wire is disconnected from the power grid 300, the control circuit 40 may control the power converter 200 to shut down, to ensure safety of the power converter 200.

In some possible implementations, the detection methods shown in FIG. 9 and FIG. 11 may further include operations in steps S100 and S300 shown in FIG. 12.

S100: In the startup process of the power converter 200, control the inverter circuit 10 to send an open-loop PWM signal.

In some possible implementations, before performing the operation in step S200 shown in FIG. 9, the control circuit 40 may control the inverter circuit 10 to send the open-loop PWM signal (open-loop ringing, OLR) in the power-on and startup process of the power converter 200.

S200: Control the target switches to be turned on. Specifically, step S200 includes the following sub-steps.

S210: Control the plurality of second switches S2 to be turned on.

S220: Control the first switch S1 corresponding to the first-phase inverter bridge arm and the first switch S1 corresponding to the N wire to be turned on.

S230: Control the inverter circuit 10 to stop sending the open-loop PWM signal.

In step S200 shown in FIG. 12 in this application, the plurality of second switches S2 are first controlled to be turned on, and then the first switch S1 corresponding to the first-phase inverter bridge arm and the first switch S1 corresponding to the N wire are controlled to be turned on. When all of the target switches are turned on, the inverter circuit 10 is controlled to stop sending the open-loop PWM signal. A first control signal of sending a PWM signal is stopped from being output to a second inverter circuit, to disable sending of the open-loop PWM signal. For example, the control circuit 40 may control, based on pulse width modulation (pulse width modulation, PWM), an on state of a switch transistor in the inverter circuit 10. This controls the inverter circuit 10 to send the open-loop PWM signal. In this implementation, after the power converter 200 is powered on and starts working, through control over sending an open-loop PWM signal, the open-loop PWM signal is sent before the target switches are turned on, and sending the open-loop PWM signal is stopped after the target switches are turned on. Duration of sending the open-loop PWM signal is within a specific range, which can control a size of a sent PWM signal, so that the PWM signal sent by the inverter circuit 10 is small. When a detection requirement is met, it can be ensured that a sent PWM signal required for detection does not cause safety and stability problems for the power converter 200.

S300: Detect whether the N wire is disconnected from the power grid 300.

For descriptions of related technical principles and technical effects of other operations in steps S200 and S300 in the embodiment shown in FIG. 12, refer to related descriptions in the embodiments shown in FIG. 8 and FIG. 9. Details are not described herein again.

In some possible implementations, based on the embodiments shown in FIG. 9, FIG. 11, and FIG. 12, the detection method further includes an operation in step S400: after it is determined that the N wire is disconnected from the power grid 300, controlling the target switches to be turned off. In this embodiment of this application, after it is determined, based on step S300, that the N wire is disconnected from the power grid 300, the control circuit 40 may control all target switches to be turned off. In this embodiment of this application, all target switches are controlled to be turned off, which can avoid a safety risk and the like caused by the target switches that are turned on when the N wire is disconnected from the power grid 300.

The control circuit in embodiments of this application may be a chip. For example, the chip may be a field programmable gate array (field programmable gate array, FPGA), an application-specific integrated chip (application-specific integrated circuit, ASIC), a system on chip (system on chip, SoC), a central processing unit (central processing unit, CPU), a network processor (network processor, NP), a digital signal processing circuit (digital signal processor, DSP), a microcontroller unit (microcontroller unit, MCU), a programmable controller (programmable logic device, PLD), or another integrated chip.

It should be understood that sequence numbers of the foregoing processes do not mean execution sequences in embodiments of this application. The execution sequences of the processes should be determined according to functions and internal logic of the processes, and should not be construed as any limitation on the implementation processes of embodiments of this application.

A person of ordinary skill in the art may be aware that in combination with the examples described in embodiments disclosed in this specification, modules and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and module, refer to a corresponding process in the foregoing method embodiments. Details are not described herein again.

In the several embodiments provided in this application, it should be understood that the disclosed system, device, and method may be implemented in other manners. For example, the described device embodiment is merely an example. For example, division into the modules is merely logical function division and may be other division during actual implementation. For example, a plurality of modules or components may be combined or integrated into another device, or some features may be ignored or not performed. In addition, the displayed or discussed mutual couplings or direct couplings or communication connections may be implemented through some interfaces. The indirect couplings or communication connections between the devices or modules may be implemented in electronic, mechanical, or other forms.

The modules described as separate parts may or may not be physically separate, and parts displayed as modules may or may not be physical modules, may be located in one device, or may be distributed on a plurality of devices. Some or all of the modules may be selected based on actual requirements to achieve the objectives of the solutions in embodiments.

In addition, functional modules in embodiments of this application may be integrated into one device, or each of the modules may exist alone physically, or two or more modules are integrated into one device.

All or some of the foregoing embodiments may be implemented by using software, hardware, firmware, or any combination thereof. When a software program is used to implement the embodiments, all or some of the embodiments may be implemented in a form of a computer program product. The computer program product includes one or more computer instructions. When the computer program instructions are loaded and executed on a computer, the procedure or functions according to embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (Digital Subscriber Line, DSL)) or wireless (for example, infrared, radio, or microwave) manner. The computer-readable storage medium may be any usable medium that can be accessed by the computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive (Solid-State Disk, SSD)), or the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power converter, comprising a busbar capacitor, an inverter circuit, a filter circuit, a switch component, and a control circuit, wherein
an input of the inverter circuit is configured to connect a positive direct current busbar and a negative direct current busbar, the positive direct current busbar and the negative direct current busbar are configured to connect a direct current power supply, and the busbar capacitor is connected between the positive direct current busbar and the negative direct current busbar;
the inverter circuit comprises three-phase inverter bridge arms and an N wire, and the N wire is connected to a midpoint of the busbar capacitor;
the inverter circuit is connected to the switch component through the filter circuit;
the filter circuit comprises three filter capacitors, and each filter capacitor is connected between the N wire and an output end of a corresponding one-phase inverter bridge arm;
the switch component is located between the filter circuit and a power grid, and comprises a plurality of first switches, and the plurality of first switches are respectively connected to the three-phase inverter bridge arms and the N wire in a one-to-one correspondence; and
the control circuit is configured to:
in a startup process of the power converter, control target switches to be turned on, wherein the target switches comprise a first switch corresponding to a first-phase inverter bridge arm of the three-phase inverter bridge arms and a first switch corresponding to the N wire, and the first-phase inverter bridge arm is any one-phase inverter bridge arm of the three-phase inverter bridge arms; and
when it is obtained that differences between an amplitude of a phase voltage of a first-phase output of the power converter and amplitudes of phase voltages of the other two-phase outputs are greater than or equal to a first threshold, send alarm information to prompt that the N wire is disconnected from the power grid, or control the power converter to shut down, wherein the first-phase output of the power converter is an output of the first-phase inverter bridge arm after the first-phase inverter bridge arm passes through the filter circuit, and the other two-phase outputs are outputs of the other two-phase inverter bridge arms after the other two-phase inverter bridge arms pass through the filter circuit.

2. The power converter according to claim 1, wherein the switch component further comprises a plurality of second switches, the plurality of second switches are connected in series to the plurality of first switches in a one-to-one correspondence, the three-phase inverter bridge arms and the N wire are respectively configured to connect to the power grid through the first switches and the second switches that are in a one-to-one correspondence, and each first switch is located between the corresponding second switch and the filter circuit, and the target switches further comprise the plurality of second switches; and
controlling the target switches to be turned on comprises:
first controlling the plurality of second switches to be turned on, and then controlling the first switch corresponding to the first-phase inverter bridge arm and the first switch corresponding to the N wire to be turned on.

3. The power converter according to claim 1 or 2, wherein the control circuit is further configured to:
before controlling the target switches to be turned on, control the inverter circuit to send an open-loop PWM signal; and
after controlling the target switches to be turned on, control the inverter circuit to stop sending the open-loop PWM signal.

4. The power converter according to any one of claims 1 to 3, wherein the control circuit is further configured to:
before obtaining the phase voltage of the first-phase output of the power converter, detect whether the target switches are turned on.

5. The power converter according to claim 4, wherein the power converter further comprises a sampling circuit, and the sampling circuit is separately connected to the switch component and the control circuit;
the sampling circuit is configured to obtain voltages at two ends of each of the target switches; and
the control circuit is specifically configured to: when a difference between voltages at two ends of any switch of the target switches is less than a preset threshold, determine that the switch is turned on.

6. The power converter according to any one of claims 1 to 5, wherein the control circuit is further configured to:
after determining that the N wire is disconnected from the power grid, control the target switches to be turned off.

7. A detection method, applied to a power converter, wherein the power converter comprises a busbar capacitor, an inverter circuit, a filter circuit, a switch component, and a control circuit; an input of the inverter circuit is configured to connect a positive direct current busbar and a negative direct current busbar, the positive direct current busbar and the negative direct current busbar are configured to connect a direct current power supply, and the busbar capacitor is connected between the positive direct current busbar and the negative direct current busbar; the inverter circuit comprises three-phase inverter bridge arms and an N wire, and the N wire is connected to a midpoint of the busbar capacitor; the inverter circuit is connected to the switch component through the filter circuit; the filter circuit comprises three filter capacitors, and each filter capacitor is connected between the N wire and an output end of a corresponding one-phase inverter bridge arm; the switch component is located between the filter circuit and a power grid, and comprises a plurality of first switches, and the plurality of first switches are respectively connected to the three-phase inverter bridge arms and the N wire in a one-to-one correspondence; and the method comprises:
in a startup process of the power converter, controlling target switches to be turned on, wherein the target switches comprise a first switch corresponding to a first-phase inverter bridge arm of the three-phase inverter bridge arms and a first switch corresponding to the N wire, and the first-phase inverter bridge arm is any one-phase inverter bridge arm of the three-phase inverter bridge arms; and
when it is obtained that differences between an amplitude of a phase voltage of a first-phase output of the power converter and amplitudes of phase voltages of the other two-phase outputs are greater than or equal to a first threshold, sending alarm information to prompt that the N wire is disconnected from the power grid, or controlling the power converter to shut down, wherein the first-phase output of the power converter is an output of the first-phase inverter bridge arm after the first-phase inverter bridge arm passes through the filter circuit, and the other two-phase outputs are outputs of the other two-phase inverter bridge arms after the other two-phase inverter bridge arms pass through the filter circuit.

8. The detection method according to claim 7, wherein the switch component further comprises a plurality of second switches, the plurality of second switches are connected in series to the plurality of first switches in a one-to-one correspondence, the three-phase inverter bridge arms and the N wire are respectively configured to connect to the power grid through the first switches and the second switches that are in a one-to-one correspondence, and each first switch is located between the corresponding second switch and the filter circuit, and the target switches further comprise the plurality of second switches; and
controlling the target switches to be turned on comprises:
first controlling the plurality of second switches to be turned on, and then controlling the first switch corresponding to the first-phase inverter bridge arm and the first switch corresponding to the N wire to be turned on.

9. The detection method according to claim 7 or 8, wherein the method further comprises:
before controlling the target switches to be turned on, controlling the inverter circuit to send an open-loop PWM signal; and
after controlling the target switches to be turned on, controlling the inverter circuit to stop sending the open-loop PWM signal.

10. The detection method according to any one of claims 7 to 9, wherein the method further comprises:
before obtaining the phase voltage of the first-phase output of the power converter, detecting whether the target switches are turned on.

11. The detection method according to claim 10, wherein the power converter further comprises a sampling circuit, the sampling circuit is connected to the switch component, and detecting whether the target switches are turned on comprises:
obtaining voltages at two ends of each of the target switches through sampling by using the sampling circuit; and
when a difference between voltages at two ends of any switch of the target switches is less than a preset threshold, determining that the switch is turned on.

12. The detection method according to any one of claims 7 to 11, wherein the detection method further comprises:
after determining that the N wire is disconnected from the power grid, controlling the target switches to be turned off.
